# EUROPÄISCHE PATENTSCHRIFT

(11) **EP 3 328 771 B1**
(45) Veröffentlichungstag und Bekanntmachung des Hinweises auf die Patenterteilung: **04.09.2019**
(21) Anmeldenummer: 16738439.5
(22) Anmeldetag: 13.07.2016
(51) Int. Cl.: B66B 5/00

(54) **VERFAHREN UND VORRICHTUNG ZUM ERMITTELN EINES BETRIEBSZUSTANDES EINER AUFZUGANLAGE**
METHOD AND DEVICE FOR DETERMINING THE OPERATING CONDITION OF A LIFT SYSTEM
PROCEDE ET DISPOSITIF DE DETERMINATION D'UN ETAT DE FONCTIONNEMENT D'UN ASCENSEUR

(30) Priorität: 29.07.2015 EP 15178768
(43) Veröffentlichungstag der Anmeldung: 06.06.2018
(73) Patentinhaber: Inventio AG, 6052 Hergiswil (CH)
(72) Erfinder: KUSSEROW, Martin, 6005 Luzern (CH); TSCHUPPERT, Reto, 6015 Luzern (CH); MOSER,Pascal Joel, 3216 Ried bei Kerzers (CH)
(86) Internationale Anmeldenummer: PCT/EP2016/066658
(87) Internationale Veröffentlichungsnummer: WO 2017/016876

(56) Entgegenhaltungen:
- WO-A1-2008/068375
- US-A1- 2003 217 894

## Beschreibung

Die Erfindung betrifft allgemein Aufzuganlagen. Insbesondere betrifft die Erfindung ein Verfahren und eine Vorrichtung zum Ermitteln eines Betriebszustandes einer Aufzuganlage. Ferner betrifft die Erfindung ein Computerprogrammprodukt zum Ausführen auf einer programmierbaren Vorrichtung sowie ein ein solches Computerprogrammprodukt speicherndes computerlesbares Medium.

Aufzuganlagen weisen in der Regel eine Mehrzahl elektrischer Verbraucher auf, wie etwa einen Antrieb, z.B. eine elektrische Maschine, für eine Kabine der Aufzuganalage, mit Hilfe dessen die Kabine zwischen Stockwerken eines Gebäudes verfahren werden kann. Ferner können Aufzuganlagen wenigstens einen Antrieb für wenigstens eine Tür der Aufzuganlage und/oder einen Sicherheitskreis aufweisen, der eine Mehrzahl von in Serie geschalteten Sicherheitsschaltern aufweisen kann und mit Hilfe dessen sichergestellt sein kann, dass die Kabine der Aufzuganlage nur bei geschlossenen Türen verfahren werden kann.

Eine Funktion und/oder ein Zustand einzelner elektrischer Verbraucher von Aufzuganlagen, insbesondere ein Betrieb und/oder eine Aktivität bzw. Inaktivität des jeweiligen Verbrauchers, kann mit diversen Sensoren, wie etwa optischen und/oder elektronischen Sensoren, überwacht werden. Eine derartige Überwachung einzelner Verbraucher kann mit erheblichem Montageaufwand und/oder mit erheblichen Kosten für Installation und Wartung der Aufzuganlage verbunden sein.

Die WO 2008/068375 A1 beschreibt ein Verfahren und ein System zur Überwachung eines Zustandes von Sicherheitsschaltern eines Sicherheitskreises eines Aufzuges, wobei der Zustand insbesondere basierend auf einer gemessenen Stromstärke eines durch den Sicherheitskreis fließenden Stromes bestimmt wird.

Es kann ein Bedarf an einem umfassenden, kostengünstig produzierbaren und mit geringem Aufwand nachrüstbaren Überwachungssystem zum Überwachen von Komponenten bzw. elektrischen Verbrauchern einer Aufzuganlage und/oder zum Ermitteln von Betriebszuständen der Aufzuganlage bestehen, wobei das Überwachungssystem in Form eines Verfahrens und einer das Verfahren ausführenden Vorrichtung bereitgestellt sein kann.

Einem solchen Bedarf kann durch den Gegenstand der unabhängigen Ansprüche entsprochen werden. Weitere Ausführungsformen der Erfindung ergeben sich aus den abhängigen Ansprüchen und aus der folgenden Beschreibung.

Gemäß einem ersten Aspekt der Erfindung wird ein Verfahren zum Ermitteln eines Betriebszustandes einer Aufzuganlage, insbesondere eines Betriebszustandes einzelner Komponenten und/oder einzelner elektrischer Verbraucher der Aufzuganlage, vorgeschlagen. Komponenten und/oder elektrische Verbraucher der Aufzuganlage können beispielsweise ein Antrieb für eine Kabine, ein oder mehrere Antriebe für eine oder mehrere Türen der Aufzuganlage sowie ein Sicherheitskreis mit wenigstens einem Sicherheitsschalter sein.

Gemäß einer Ausführungsform der Erfindung weist das Verfahren einen Schritt des Ermittelns eines Stromzeitverlaufs eines der Aufzuganlage über eine Stromversorgungsleitung der Aufzuganlage zugeführten Stromes und einen Schritt des Identifizierens wenigstens eines Stromverlaufssegments des erfassten Stromzeitverlaufs auf. Weiter weist das Verfahren einen Schritt des Ableitens eines Stromverlaufsmusters des identifizierten Stromverlaufssegments und einen Schritt des Ermittelns des Betriebszustandes der Aufzuganlage basierend auf einem Vergleich des Stromverlaufsmusters mit wenigstens einem Referenzmuster auf.

Das Ermitteln des Stromzeitverlaufs kann dabei ein mittelbares und/oder unmittelbares bzw. direktes und/oder indirektes Messen, Ermitteln und/oder Bestimmen einer der Aufzuganlage über die Stromversorgungsleitung zugeführten Stromstärke als Funktion der Zeit darstellen. Der Stromzeitverlauf kann somit einen zeitlichen Stromverlauf bezeichnen. Weiter kann der Schritt des Ermittelns des Stromzeitverlaufs ein Ermitteln einzelner und/oder mehrerer Phasen eines der Aufzuganlage über die Stromversorgungsleitung zugeführten Stromes umfassen. Der Strom kann dabei insbesondere ein Speisestrom, etwa ein dreiphasiger Speisestrom, der Aufzuganlage sein.

Allgemein kann der Begriff des Betriebszustandes eine Funktion, eine Aktivität bzw. Inaktivität, aufzugsanlagenspezifische Ereignisse und/oder einen Betrieb der Aufzuganlage und/oder einzelner elektrischer Verbraucher der Aufzuganlage bezeichnen.

Das Stromverlaufssegment des erfassten Stromzeitverlaufs kann ein oder mehrere Intervalle des Stromzeitverlaufs bezeichnen. Auch kann das Stromverlaufssegment den gesamten über eine gewisse Zeitdauer ermittelten Stromzeitverlauf bezeichnen. Das Stromverlaufssegment kann etwa über eine Anfangszeit, eine Endzeit und/oder eine Zeitdauer des Stromverlaufssegments identifiziert werden. Entsprechend kann der Schritt des Identifizierens des Stromverlaufssegments einen Schritt des Festlegens und/oder Bestimmens der Anfangszeit, der Endzeit und/oder der Zeitdauer des jeweiligen Stromverlaufssegments aufweisen.

Allgemein kann das aus dem Stromverlaufssegment abgeleitete Stromverlaufsmuster einen Verlauf des Stromes in dem gesamten und/oder nur einem Teil des Stromverlaufssegments charakterisieren und/oder bezeichnen. Beispielsweise kann das Stromverlaufsmuster wenigstens ein Charakteristikum des Stromzeitverlaufs in dem Stromverlaufssegment aufweisen, darstellen und/oder charakterisieren, wie insbesondere ein Maximum, ein Minimum, einen Peak, eine Flanke, einen Anstieg, einen Abfall und/oder einen Gradienten des Stromzeitverlaufs.

Das zum Vergleich mit dem Stromverlaufsmuster herangezogene Referenzmuster kann beispielsweise in einer Speichervorrichtung hinterlegt sein. Auch kann nur ein Teil des Referenzmusters in der Speichervorrichtung hinterlegt sein und das Referenzmuster kann basierend auf dem hinterlegten Teil rekonstruiert werden, beispielsweise durch Skalierung, Wichtung, Interpolation und/oder Extrapolation.

Ideen zu Ausführungsformen Erfindung können unter anderem als auf den nachfolgend beschriebenen Gedanken und Erkenntnissen beruhend angesehen werden.

Einzelne elektrischer Verbraucher bzw. Komponenten der Aufzuganlage können einen für den jeweiligen Verbraucher charakteristischen Stromverbrauch in einem jeweiligen Betriebszustand des elektrischen Verbrauchers bzw. der Aufzuganlage aufweisen. Ein möglicher Betriebszustand der Aufzuganlage kann beispielsweise eine Aufwärtsfahrt der Kabine sein, wobei ein für die Aufwärtsfahrt aufzuwendender Stromverbrauch des Antriebs der Kabine als Funktion der Zeit unabhängig von einer mit der Kabine beförderten Last Ähnlichkeiten bzw. Charakteristika aufweisen kann. Derartige Charakteristika können erfindungsgemäß in Form eines Referenzmusters z.B. in einer Speichervorrichtung hinterlegt sein. In dem Speicher kann so eine Vielzahl von Referenzmustern hinterlegt sein, wobei jedes der Referenzmuster einem Betriebszustand wenigstens eines elektrischen Verbrauchers der Aufzuganlage zugeordnet sein kann.

Erfindungsgemäß kann während des Betriebes der Aufzugsanlage die Stromstärke des der Aufzuganlage und/oder Komponenten bzw. elektrischen Verbrauchern der Aufzuganlage über die Stromversorgungsleitung zugeführten Stromes als Funktion der Zeit ermittelt, gemessen und/oder bestimmt werden. Aus dem ermittelten Stromzeitverlauf kann ein Stromverlaufssegment bestimmt, ausgewählt und/oder identifiziert werden. Aus dem Stromverlaufssegment kann wenigstens ein Charakteristikum als Stromverlaufsmuster abgeleitet, ermittelt und/oder bestimmt werden. Das Stromverlaufsmuster kann dann mit einem, mehreren oder allen in der Speichervorrichtung hinterlegten Referenzmustern verglichen werden. Basierend auf dem Vergleich kann ein Referenzmuster ausgewählt werden, welches dem ermittelten Stromverbrauch bzw. dem aus dem Stromzeitverlauf abgeleiteten Stromverlaufsmuster am ähnlichsten sein kann und/oder mit diesem im Wesentlichen übereinstimmen kann. Da jedes der Referenzmuster wiederum einem bestimmten Betriebszustand der Aufzuganlage bzw. einem bestimmten Betriebszustand eines bestimmten elektrischen Verbrauchers der Aufzuganlage zugeordnet sein kann, kann so auf den Betriebszustand der Aufzuganlage rückgeschlossen werden. Mit anderen Worten kann mittelbar über eine Messung eines differentiellen Stromverbrauchs und über einen Vergleich des Stromverbrauchs mit Referenzmustern der Betriebszustand der Aufzuganlage und so auch der Betriebszustand eines einzelnen Verbrauchers der Aufzuganlage in vorteilhafter Weise bestimmt werden.

Darüber hinaus kann mit Hilfe des erfindungsgemäßen Verfahrens ohne personellen Einsatz eine Funktionalität der Aufzuganlage kontinuierlich und über einen langen Zeitraum automatisiert kontrolliert und/oder überwacht werden, und eine Fehlfunktion der Aufzuganlage kann beispielsweise durch Abweichung des ermittelten Stromverlaufsmusters von dem Referenzmuster detektiert bzw. identifiziert werden. Gleichzeitig kann dabei ein einzelner unter Umständen fehlerhafter elektrischer Verbraucher, wie beispielsweise ein Antrieb für eine Tür, bestimmt werden. Dies wiederum kann eine Wartung der Aufzuganlage vereinfachen. Auch kann ein Totalausfall, etwa durch Ausfall der Stromversorgung der Aufzuganlage, automatisch detektiert werden. Insgesamt können so Ausfälle bzw. Fehlfunktionen der Aufzuganlage schnell erkannt werden.

Optional kann ferner ein Wert eines dem Betriebszustand zugeordneten Betriebszustandsparameters in einer Speichervorrichtung hinterlegt werden. Der Betriebszustandsparameter kann beispielsweise ein Zähler sein, dessen Wert angeben kann, wie oft ein bestimmter Betriebszustand bisher aufgetreten ist. Auch kann der Betriebszustandsparameter ein Indikator, z.B. ein Flag, sein, dessen Wert ein Vorliegen oder Nichtvorliegen eines gewissen Betriebszustandes anzeigen kann.

Durch Hinterlegen eines Wertes eines dem ermittelten Betriebszustand zugeordneten Betriebszustandsparameters in der Speichervorrichtung kann ferner eine Statistik über die Benutzung der Aufzuganlage angefertigt werden. Dies wiederum kann es erlauben, beispielsweise eine erwartungsgemäß verbleibende Lebensdauer der Aufzuganlage und/oder einzelner Verbraucher der Aufzuganlage abzuschätzen. Insgesamt können so Ausfälle bzw. Fehlfunktionen der Aufzuganlage vermieden oder gering gehalten werden.

Ein zweiter Aspekt der Erfindung betrifft eine Vorrichtung zum Ermitteln eines Betriebszustandes einer Aufzuganlage, wobei die Vorrichtung dazu ausgeführt ist, das Verfahren so wie obenstehend und untenstehend beschrieben auszuführen.

Es ist zu verstehen, dass Merkmale des Verfahrens so wie obenstehend und untenstehend beschrieben auch Merkmale der Vorrichtung sein können und umgekehrt.

Ein dritter Aspekt der Erfindung betrifft ein Computerprogrammprodukt, welches maschinenlesbare Anweisungen aufweist, welche eine programmierbare Vorrichtung wie beispielsweise einen Computer oder ein programmierbares Steuergerät zum Ausführen des Verfahrens so wie obenstehend und untenstehend beschrieben anweisen.

Ein vierter Aspekt der Erfindung betrifft ein computerlesbares Medium mit einem darauf gespeicherten Computerprogrammprodukt wie obenstehend und untenstehend beschrieben. Ein computerlesbares Medium kann dabei z.B. eine Diskette, eine Harddisk, ein USB-Speichergerät, ein RAM, ein ROM ein EPROM sein. Ein computerlesbares Medium kann auch ein Datenkommunikationsnetzwerk, wie beispielsweise das Internet, das den Download eines Programmcodes ermöglicht, sein.

Gemäß einer Ausführungsform der Erfindung wird der Stromzeitverlauf in der Stromversorgungsleitung mit wenigstens einem galvanisch von der Stromversorgungsleitung getrennten Sensorelement ermittelt. Zum einen kann dies den Vorteil haben, dass vorrübergehende Stromstöße und/oder Überspannungen in der Stromversorgungsleitung das Sensorelement nicht schädigen können und zum anderen kann das Sensorelement während des Betriebes der Aufzuganlage montiert werden, ohne dass etwa die Stromversorgungsleitung zu diesem Zwecke unterbrochen werden müsste. Mit anderen Worten kann ein galvanisch von der Stromversorgungsleitung getrenntes Sensorelement ohne Unterbrechung eines Stromkreises appliziert werden, was wiederum Installationskosten senken kann. Auch bedarf ein Anbringen des Sensorelements keines speziell, etwa im Umgang mit Hochspannung, geschulten Personals.

Gemäß einer Ausführungsform der Erfindung umfasst die Stromversorgungsleitung eine Hauptversorgungsleitung zu einem Schaltschrank der Aufzuganlage. Die Stromversorgungsleitung kann Gleichstrom oder Wechselstrom, insbesondere mehrphasigen Wechselstrom, führen und eine Vielzahl von elektrischen Verbrauchern der Aufzuganlage mit elektrischer Energie versorgen. Der Stromzeitverlauf kann dabei an einer oder mehreren Phasen der Stromversorgungsleitung ermittelt werden. Insbesondere kann der Stromzeitverlauf an einer Phase der Stromversorgungsleitung ermittelt werden, welche mit einem Antrieb einer Tür der Aufzuganlage verbunden sein kann, so dass ein Betriebszustand der Tür ermittelt werden kann. Durch das Ermitteln des Stromzeitverlaufs an einer Hauptversorgungsleitung kann so in vorteilhafter Weise zentral eine Vielzahl von Verbrauchern der Aufzuganlage überwacht werden und deren Betriebszustände können an einem Ort ermittelt werden. Dies kann Installationskosten und/oder Wartungskosten für das erfindungsgemäße Überwachungssystem reduzieren. Auch muss dadurch nicht zwingend eine Steuerungsvorrichtung der Aufzuganlage modifiziert werden, so dass für Installationsarbeiten nicht zwingend speziell geschultes Personal erforderlich ist.

Gemäß einer Ausführungsform der Erfindung wird der Betriebszustand unter Berücksichtigung von aufzugspezifischen Ausschlusskriterien und/oder aufzugspezifischen Randbedingungen ermittelt. Mögliche Betriebszustände der Aufzuganlage können etwa in Klassen eingeteilt bzw. klassifiziert werden, welche sich zumindest teilweise ausschließen können. Beispielsweise kann eine Klasse von Betriebszuständen eine Aktivität des Antriebs der Kabine und eine weitere Klasse eine Aktivität eines Antriebs einer Tür sein. Aus sicherheitstechnischen Vorkehrungen und aufgrund von hardwaremäßigen Sicherheitsvorkehrungen der Aufzuganlage ist es in der Regel ausgeschlossen, dass eine Tür während einer Fahrt der Kabine betätigt wird. Dies wiederum kann als Ausschlusskriterium bei der Ermittlung eines Betriebszustandes herangezogen werden. Indiziert etwa ein Stromverlaufsmuster eine Aktivität des Antriebs der Kabine, so kann gemäß der Klassifizierung der Betriebszustände und den entsprechenden Ausschlusskriterien ausgeschlossen werden, dass gleichzeitig ein Antrieb der Tür aktiv war. Referenzmuster, welche dem Betriebszustand der Aktivität des Türantriebs zugeordnet sind, können daher in einem solchen Fall ausgeschlossen werden und müssen bei der Ermittlung des tatsächlichen Betriebszustandes nicht zwingend herangezogen werden bzw. nicht zwingend mit dem Stromverlaufsmuster verglichen werden. Auch weitere aufzugspezifische Randbedingungen, wie etwa dass in der Regel vor einer Kabinenfahrt die Aufzugtür geschlossen und nach einer Kabinenfahrt die Aufzugtür geöffnet wird, können bei der Ermittlung der Betriebszustände berücksichtigt werden. Insgesamt kann die Berücksichtigung von aufzugspezifischen Ausschlusskriterien und/oder Randbedingungen eine Geschwindigkeit der Ermittlung des Betriebszustandes erhöhen und eine Genauigkeit der Bestimmung steigern.

Gemäß einer Ausführungsform der Erfindung weist das Stromverlaufsmuster wenigstens einen für einen jeweiligen Betriebszustand charakteristischen Parameter auf. Mögliche Parameter können unter anderem eine Standardabweichung zumindest eines Teilbereichs des Stromzeitverlaufs eines Stromverlaufssegments, ein Maximalwert des Stromes, ein Schwellenwert des Stromes, ein Mittelwert des Stromes, ein Gradient des Stromes, eine Anzahl lokaler Maxima oder Minima in dem Stromverlaufssegment und/oder ein (zeitlicher) Abstand von Peaks in dem Stromverlaufssegment sein. Zudem kann ein Wert im Frequenzbereich des Stromverlaufssegments berücksichtigt werden, der mittels beispielsweise einer Fourier- oder Wavelet-Transformation berechenbar ist. Auch kann das Stromverlaufsmuster beispielsweise entsprechende wenigstens einen Parameter integrierende Größen, wie beispielsweise einen Stromverbrauch über eine gewisse Zeitdauer, aufweisen. Das Stromverlaufsmuster kann beispielsweise ein Vektor oder eine Matrix von derartigen Parametern sein, welche charakteristisch für einen bestimmten Betriebszustand sein können bzw. welche einem bestimmten Betriebszustand zugeordnet sein können.

Gemäß einer Ausführungsform der Erfindung umfasst der Schritt des Ableitens des Stromverlaufsmusters ein Bestimmen eines Wertes des für den jeweiligen Betriebszustand charakteristischen wenigstens einen Parameters. Basierend auf der Bestimmung des Wertes des wenigstens einen Parameters kann so ein aussagekräftiger Vergleich mit dem Referenzmuster und damit eine zuverlässige Ermittlung des Betriebszustandes durchgeführt werden.

Gemäß einer Ausführungsform der Erfindung weist das Referenzmuster wenigstens einen für den jeweiligen Betriebszustand charakteristischen Referenzparameter auf. Analog den Parametern des Stromverlaufsmuster können mögliche Referenzparameter unter anderem eine Standardabweichung, ein Maximalwert des Stromes, ein Schwellenwert des Stromes, ein Gradient des Stromes, eine Anzahl lokaler Maxima oder Minima und/oder ein (zeitlicher) Abstand von Peaks sein. Auch kann das Referenzmuster bzw. der entsprechende wenigstens eine Referenzparameter integrale Größen, wie beispielsweise einen Stromverbrauch über eine gewisse Zeitdauer, aufweisen. Das Referenzmuster kann ein Vektor oder eine Matrix von derartigen Referenzparametern sein. Mit anderen Worten kann das Referenzmuster eine Liste bzw. Zusammenstellung von für den jeweiligen Betriebszustand charakteristischen Referenzparametern sein.

Gemäß einer Ausführungsform der Erfindung wird der jeweilige Betriebszustand basierend auf einem Vergleich des Wertes des wenigstens einen für den jeweiligen Betriebszustand charakteristischen Parameters mit einem Referenzwert des wenigstens einen Referenzparameters des Referenzmusters ermittelt. Dies kann in vorteilhafter Weise eine zuverlässige und automatisierte Ermittlung des Betriebszustandes erlauben.

Gemäß einer Ausführungsform der Erfindung umfasst der Schritt des Ableitens des Stromverlaufsmusters des Stromverlaufssegments insbesondere ein Ermitteln einer Standardabweichung, eines Maximalwerts, eines Schwellenwertes, eines Integrals und/oder eines Gradienten des Stromes in dem Stromverlaufssegment. Auch integrale Größen, eine Anzahl lokaler Maxima oder Minima und/oder ein (zeitlicher) Abstand von Peaks kann ermittelt werden. Mit anderen Worten können zur Ableitung des Stromverlaufsmusters Werte der für einen jeweiligen Betriebszustand charakteristischen Parameter ermittelt, bestimmt und/oder berechnet werden.

Gemäß einer Ausführungsform der Erfindung umfasst der Schritt des Identifizierens des wenigstens einen Stromverlaufssegments ein Segmentieren des erfassten Stromzeitverlaufs in Stromverlaufssegmente. Beispielsweise kann der Stromzeitverlauf in diskrete Stromverlaufssegmente unterteilt werden, welche etwa Zeitsegmente bzw. Zeitintervalle des Stromzeitverlaufs bezeichnen können. Einzelne Stromverlaufssegmente können dann wiederum einzelnen Betriebszuständen, über Vergleich mit den entsprechenden Referenzmustern, zugeordnet werden. Derart kann eine Güte bzw. Genauigkeit der Ermittlung der Betriebszustände gesteigert werden. Auch kann durch die Segmentierung sowie gegebenenfalls unter Berücksichtigung oben genannter Ausschlusskriterien die Ermittlung der Betriebszustände beschleunigt werden.

Gemäß einer Ausführungsform der Erfindung weist das Verfahren weiter einen Schritt des Auswählens eines Stromverlaufssegments, das die Basis bildet für die Ermittlung eines Stromverlaufsmusters als Referenzmuster und/oder einen Schritt des Hinterlegens des Stromverlaufsmusters als Referenzmuster in einer Speichervorrichtung auf. Derartige Funktionen können insbesondere für eine Lernphase des Überwachungssystems für Aufzuganlagen relevant sein. Da sich unterschiedliche Aufzuganlagen anlagenspezifisch in ihrem Stromverbrauch, insbesondere ihrem differentiellen Stromverbrauch, unterscheiden können, kann es erforderlich sein, z.B. nach Installation des erfindungsgemäßen Überwachungssystems anlagenspezifische Charakteristika bezüglich des Stromverbrauchs der Aufzuganlage und/oder einzelner Verbraucher in Form wenigstens eines Referenzmusters in der Speichervorrichtung zu hinterlegen. Beispielsweise könnte zu diesem Zweck wenigstens ein definierbarer Testlauf der Aufzuganlage durchgeführt werden, wobei Stromverlaufsmuster ermittelt werden und als Referenzmuster abgespeichert werden können, so dass während des regulären Betriebs der Aufzuganlage basierend auf diesen Referenzmustern Betriebszustände ermittelt werden können. Das erfindungsgemäße Überwachungssystem kann daher selbstlernend ausgestaltet sein. Auch kann das Überwachungssystem dazu ausgestaltet sein, nach gewissen Zeitintervallen die in der Speichervorrichtung hinterlegten Referenzmuster zu aktualisieren, beispielsweise um Änderungen im differentiellen Stromverbrauch der Aufzuganlage zu kompensieren und/oder zu berücksichtigen. Derartige Funktionen können automatisch, durch einen Techniker vor Ort und/oder per Fernwartung initiiert und/oder durchgeführt werden.

Gemäß einer Ausführungsform der Erfindung umfasst der ermittelte Betriebszustand einen Bewegungszustand einer Kabine der Aufzuganlage, eine Anzahl von mit der Kabine angefahrenen Stockwerken, eine Anzahl vollständiger Fahrzyklen der Kabine, einen Betriebszustand einer Aufzugtür, eine Position der Kabine und/oder einen Betriebszustand eines Sicherheitskreises der Aufzuganlage. Der Bewegungszustand der Kabine kann beispielswiese ein Standby bzw. Ruhezustand, eine relative und/oder absolute Standby-Zeit, eine relative und/oder absolute Fahrzeit, eine Aufwärtsbewegung und/oder eine Abwärtsbewegung sein. Der Betriebszustand der Aufzugtür kann beispielsweise ein offene, eine geschlossene, eine öffnende, eine schließende und/oder eine Anzahl von Türbewegungen sein. Die Betriebszustände der Aufzuganlage können in Form der Betriebszustandsparametern in der Speichervorrichtung hinterlegt sein, wobei deren Werte dynamisch während des Betriebes der Aufzuganlage aktualisiert, angepasst und/oder modifiziert werden können.

Gemäß einer Ausführungsform der Erfindung weist die Vorrichtung zum Ermitteln eines Betriebszustandes einer Aufzuganlage wenigstens ein Sensorelement, eine Speichervorrichtung und einen Controller auf. Das Sensorelement ist dazu ausgeführt, den Stromzeitverlauf des der Aufzuganlage über die Stromversorgungsleitung der Aufzuganlage zugeführten Stromes zu ermitteln. Der Controller ist dazu ausgeführt, das wenigstens eine Stromverlaufssegment des ermittelten Stromzeitverlaufs zu identifizieren, das Stromverlaufsmuster des identifizierten Stromverlaufssegments abzuleiten, das Stromverlaufsmuster mit dem wenigstens einen Referenzmuster zu vergleichen, den Betriebszustand der Aufzuganlage basierend auf dem Vergleich zu ermitteln, und einen Wert wenigstens eines dem Betriebszustand zugeordneten Betriebszustandsparameters in der Speichervorrichtung zu hinterlegen. Die Vorrichtung kann insbesondere eine Sensorvorrichtung bezeichnen. Der Controller kann allgemein eine Datenverarbeitungsvorrichtung, einen Prozessor, eine Logikvorrichtung, einen Mikrocontroller und/oder dergleichen bezeichnen. Weiter kann die Vorrichtung beispielsweise einen Analog-Digital-Konverter und/oder eine Filtervorrichtung, beispielsweise einen Tiefpass-Filter aufweisen, mit Hilfe dessen Signale des Sensorelements gefiltert werden können.

Gemäß einer Ausführungsform der Erfindung weist das Sensorelement einen induktiven Stromsensor und/oder einen Hall-Sensor auf. Derartige Sensorelemente können in vorteilhafter Weise unterbrechungsfrei an der Stromversorgungsleitung (d.h. ohne Unterbrechung eines Stromkreises) appliziert und/oder montiert werden. Ferner können sich derartige Sensorelemente durch einen geringen Stromverbrauch und eine lange Lebensdauer auszeichnen.

Gemäß einer Ausführungsform der Erfindung weist die Vorrichtung eine Mehrzahl von Sensorelementen auf, welche jeweils dazu ausgeführt sind, einen Stromzeitverlauf einer einzelnen Phase des der Aufzuganlage über die Stromversorgungsleitung zugeführten Stromes zu ermitteln.

Gemäß einer Ausführungsform der Erfindung weist die Vorrichtung ein weiteres Sensorelement auf, wobei das weitere Sensorelement dazu ausgeführt ist, einen Stromzeitverlauf eines Stromes in einem Sicherheitskreis der Aufzuganlage zu erfassen. Derart kann auch ein Betriebszustand des Sicherheitskreises und/oder von Sicherheitsschaltern des Sicherheitskreises ermittelt werden.

Gemäß einer Ausführungsform der Erfindung weist die Vorrichtung weiter eine Energiequelle zum Versorgen der Vorrichtung mit elektrischer Energie auf.

Gemäß einer Ausführungsform der Erfindung weist die Energiequelle einen Energiespeicher auf, der dazu ausgeführt ist, zumindest teilweise über ein von in der Stromversorgungsleitung fließendem Strom erzeugtes Magnetfeld geladen zu werden. Der Energiespeicher kann eine aufladbare Batterie, ein Akkumulator, ein Kondensator, eine Kapazität oder jedweder anderer elektrischer Energiespeicher sein. Durch das zumindest teilweise Aufladen des Energiespeichers über das Magnetfeld der Stromversorgungsleitung kann in vorteilhafter Weise eine Montage der Vorrichtung vereinfacht sein, da keine Verdrahtung der Vorrichtung mit einer Versorgungsleitung erforderlich ist. Insbesondere kann dadurch eine Montage durch speziell geschultes Personal entfallen. Auch kann eine Notwendigkeit eines Eingriffs in Stromkreise der Aufzuganlage vermieden werden.

Gemäß einer Ausführungsform der Erfindung weist die Vorrichtung weiter eine Kommunikationsvorrichtung zum Übermitteln von in der Speichervorrichtung hinterlegten Werten von Betriebszuständen der Aufzuganlage zugeordneten Betriebszustandsparametern auf. Die Kommunikationsvorrichtung kann insbesondere eine Schnittstelle, beispielsweise eine Bus-Schnittstelle, zur Vorrichtung bezeichnen. Daten können insbesondere drahtlos über die Kommunikationsvorrichtung übermittelt werden. Die Kommunikationsvorrichtung kann ferner an das Internet angeschlossen sein, um eine Fernwartung zu erlauben. Auch kann die Kommunikationsvorrichtung eine NFC-Schnittstelle ("Near-Field Communication") zur kontaktlosen Datenübermittlung z.B. mit einem mobilen Endgerät aufweisen. Über die Kommunikationsvorrichtung können beispielsweise Stromverlaufsmuster und/oder Werte der zugehörigen Parameter aus der Speichervorrichtung ausgelesen werden. Auch können Werte der Betriebszustandsparameter ausgelesen werden. Auch Referenzwerte der Referenzparameter der Referenzmuster können über die Kommunikationsvorrichtung in der Speichervorrichtung hinterlegt und/oder ausgelesen werden.

Insgesamt ist zu verstehen, dass die beschriebenen Schritte des Verfahrens als programmierte Softwaremodule, funktionale Module und/oder Funktionen in der Vorrichtung implementiert sein können. Es ist jedoch möglich, dass diese funktionalen Module auch teilweise oder vollständig als Hardware implementiert sind.

Falls technisch möglich, aber nicht explizit genannt, sind auch Kombinationen von Ausführungsformen so wie obenstehend und untenstehend beschrieben auch Ausführungsformen der Vorrichtung.

Im Folgenden werden Ausführungsbeispiele der Erfindung mit Bezug auf die beiliegenden Figuren detailliert beschrieben.
Fig. 1 zeigt eine Vorrichtung zum Ermitteln eines Betriebszustandes einer Aufzuganlage gemäß einer Ausführungsform der Erfindung.
Fig. 2 zeigt eine Vorrichtung zum Ermitteln eines Betriebszustandes einer Aufzuganlage gemäß einer weiteren Ausführungsform der Erfindung.
Fig. 3 zeigt eine Vorrichtung zum Ermitteln eines Betriebszustandes einer Aufzuganlage gemäß einer weiteren Ausführungsform der Erfindung.
Fig. 4 zeigt ein Flussdiagramm zur Illustration von Schritten eines erfindungsgemäßen Verfahrens zum Ermitteln eines Betriebszustandes einer Aufzuganlage gemäß einer Ausführungsform der Erfindung.
Fig. 5 zeigt einen exemplarischen im Rahmen des Verfahrens der Fig. 4 ermittelten Stromzeitverlauf.

Die Figuren sind lediglich schematisch und nicht maßstabsgetreu. Die in den Figuren verwendeten Bezugszeichen und ihre Bedeutung sind in zusammenfassender Form in der Liste der Bezugszeichen aufgeführt. Grundsätzlich sind identische oder ähnliche Teile mit den gleichen Bezugszeichen versehen.

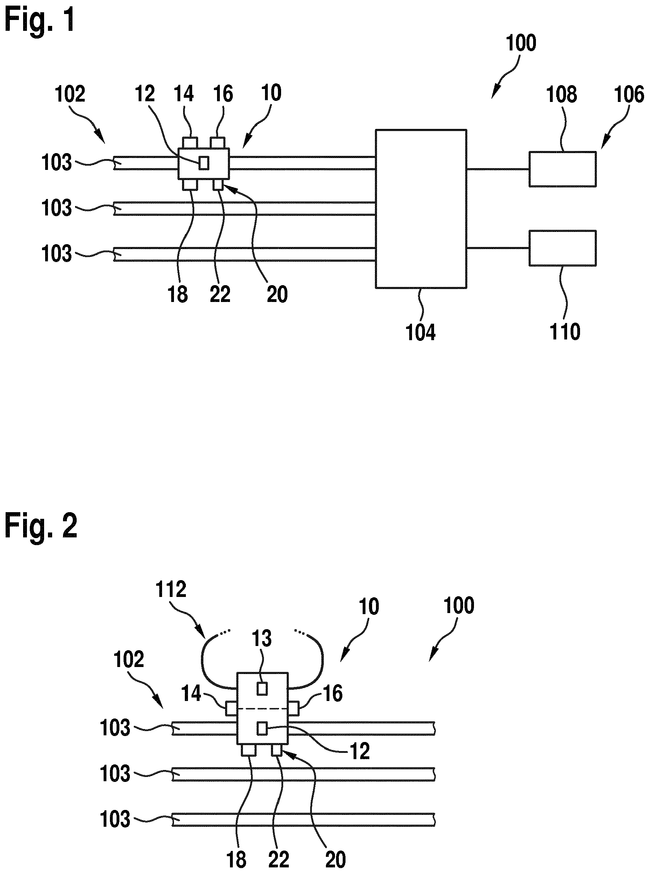

Fig. 1 zeigt eine Vorrichtung 10 zum Ermitteln eines Betriebszustandes einer Aufzuganlage 100 gemäß einer Ausführungsform der Erfindung.

Die Aufzuganlage 100 weist eine Stromversorgungsleitung 102 auf, welche Gleichstrom oder Wechselstrom führen kann. Insbesondere kann die Stromversorgungsleitung 102 drei Phasen 103 von Wechselstrom führen. Die Stromversorgungsleitung 102 kann beispielsweise eine Hauptversorgungsleitung der Aufzuganlage 100 sein und z.B. an einen Schaltschrank 104 der Aufzuganlage 100 angeschlossen sein. Letztendlich kann die Stromversorgungsleitung 102 zur Stromversorgung einer Mehrzahl von elektrischen Verbrauchern 106 der Aufzuganlage 100 dienen. Die elektrischen Verbraucher 106 können jeweils mit elektrischen Leitungen an den Schaltschrank 104 angeschlossen sein und beispielsweise wenigstens einen Antrieb für eine Tür bzw. einen Türantrieb 108 in Form einer elektrischen Maschine aufweisen. Weiter können die elektrischen Verbraucher 106 einen Antrieb zum Verfahren einer Kabine der Aufzuganlage 100 bzw. einen Kabinenantrieb 110 in Form einer weiteren elektrischen Maschine aufweisen.

Diverse weitere elektrische Verbraucher 106 können über die Stromversorgungsleitung 102 und über den Schaltschrank 104 betrieben werden, wie beispielsweise ein Kabinenbedienpanel (COP - Cabin Operating Panel), Beleuchtungen, Anzeigen, etc..

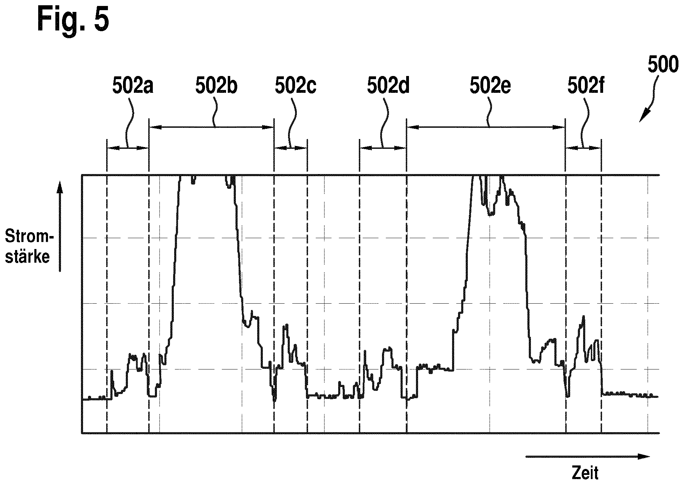

Die Vorrichtung 10 zum Ermitteln eines Betriebszustandes der Aufzuganlage 100 weist ein Sensorelement 12 auf. Das Sensorelement 12 ist dabei an der Stromversorgungsleitung 102 bzw. an einer Phase 103 der Stromversorgungsleitung 102 angeordnet und/oder an diese gekoppelt. Insbesondere kann das Sensorelement 12 an derjenigen Phase 103 angeschlossen sein, über welche der Türantrieb 108 mit elektrischer Energie versorgt wird, so dass ein dem Türantrieb 108 zugeführter Strom mit dem Sensorelement 12 ermittelt werden kann. Das Sensorelement 12 ist galvanisch von der Stromversorgungsleitung 102 getrennt. Beispielsweise kann das Sensorelement 12 einen Hall-Sensor oder einen induktiven Sensor aufweisen, welcher ohne elektrische Verbindung zwischen dem Sensorelement 12 und der Stromversorgungsleitung 102 eine über die Stromversorgungsleitung 102 der Aufzuganlage 100 zugeführte Stromstärke ermitteln, bestimmen und/oder messen kann. Allgemein ist das Sensorelement 12 dazu ausgelegt, einen Stromzeitverlauf 500 (siehe Fig. 5), d.h. eine Stromstärke als Funktion der Zeit, des der Aufzuganlage 100 über die Stromversorgungsleitung 102 zugeführten Stromes zu ermitteln. Mit anderen Worten ist das Sensorelement 12 dazu ausgelegt, zeitaufgelöst die der Aufzuganlage 100 in zumindest einer Phase 103 der Stromversorgungsleitung 102 zugeführte Stromstärke zu ermitteln. Das Sensorelement 12 kann die Stromstärke dazu kontinuierlich oder quasi-kontinuierlich mit einer gewissen Abtastrate ermitteln, wobei die Abtastrate zwischen wenigen 10 Hz, z.B. bei einem Gleichstrom in der Stromversorgungsleitung 102, bis einige kHz oder höher betragen kann, so dass auch ein Wechselstrom mit hoher Genauigkeit ermittelt bzw. abgetastet werden kann.

Die Vorrichtung 10 weist ferner eine Speichervorrichtung 14 zum Speichern und/oder Abrufen von Daten, Parametern, Größen und dergleichen auf. Die Speichervorrichtung 14 kann beispielsweise einen RAM-Speicher (random access memory), einen Flash-Speicher und/oder jedwede andere Art von Datenspeicher aufweisen.

Weiter weist die Vorrichtung 10 einen Controller 16 auf. Der Controller 16 ist insbesondere dazu ausgeführt, vom Sensorelement 12 ermittelte Daten und/oder Signale des Sensorelements 12 zu verarbeiten und/oder auszuwerten, so wie obenstehend und untenstehend im Detail erläutert. Der Controller 16 kann dazu eine Datenverarbeitungsvorrichtung, einen Prozessor, eine Logikvorrichtung, einen Mikrocontroller und/oder dergleichen aufweisen.

Weiter weist die Vorrichtung 10 eine Kommunikationsvorrichtung 18 auf, welche eine Schnittstelle aufweisen kann, über welche insbesondere ein Zugriff auf in der Speichervorrichtung 14 hinterlegte Daten bereitgestellt sein kann, so wie obenstehend und untenstehend m Detail erläutert. Die Kommunikationsvorrichtung 18 kann beispielsweise eine Bus-Schnittstelle aufweisen. Die Kommunikationsvorrichtung 18 kann ferner an das Internet angeschlossen sein, um eine Fernwartung der Vorrichtung 10 zu erlauben. Auch kann die Kommunikationsvorrichtung 18 eine NFC-Schnittstelle ("Near-Field Communication") zur kontaktlosen Datenübermittlung z.B. mit einem mobilen Endgerät aufweisen.

Ferner weist die Vorrichtung 10 eine Energiequelle 20 zum Versorgen der Vorrichtung 10 mit elektrischer Energie auf, wobei die Energiequelle 20 einen Energiespeicher 22 aufweist, der dazu ausgeführt ist, zumindest teilweise über ein von in der Stromversorgungsleitung 102 fließendem Strom erzeugtes Magnetfeld geladen zu werden. Der Energiespeicher 22 kann eine aufladbare Batterie, ein Akkumulator, ein Kondensator, eine Kapazität oder jedweder anderer elektrischer Energiespeicher sein.

Fig. 2 zeigt eine Vorrichtung 10 zum Ermitteln eines Betriebszustandes einer Aufzuganlage 100 gemäß einer weiteren Ausführungsform der Erfindung. Sofern nicht anders beschrieben, kann die Vorrichtung 10 der Fig. 2 dieselben Elemente und Merkmale aufweisen wie die Vorrichtung 10 der Fig.l. Der Übersichtlichkeit halber sind einige Komponenten der Aufzuganlage 100 in Fig. 2 nicht gezeigt.

Bei der in Fig. 2 gezeigten Ausführungsform weist die Aufzuganlage 100 einen Sicherheitskreis 112 auf, welcher wiederum eine Mehrzahl von in Serie geschalteten Sicherheitsschaltern (nicht dargestellt) aufweisen kann. Beispielsweise kann bei einer geöffneten Tür der Aufzuganlage 100 und/oder bei Betrieb des Türantriebs 108 wenigstens einer der Sicherheitsschalter geöffnet sein, wodurch ein gleichzeitiger Betrieb des Kabinenantriebs 110 ausgeschlossen bzw. verhindert sein kann.

Die Vorrichtung 10 der Fig. 2 weist ein weiteres Sensorelement 13 auf, welches an den Sicherheitskreis 112 gekoppelt ist und welches dazu ausgelegt ist, einen Stromzeitverlauf eines Stromes in dem Sicherheitskreis 112 zu ermitteln, zu erfassen und/oder zu messen. Auch das weitere Sensorelement 13 ist galvanisch von dem Sicherheitskreis 112 getrennt und kann einen induktiven Sensor oder einen Hall-Sensor aufweisen.

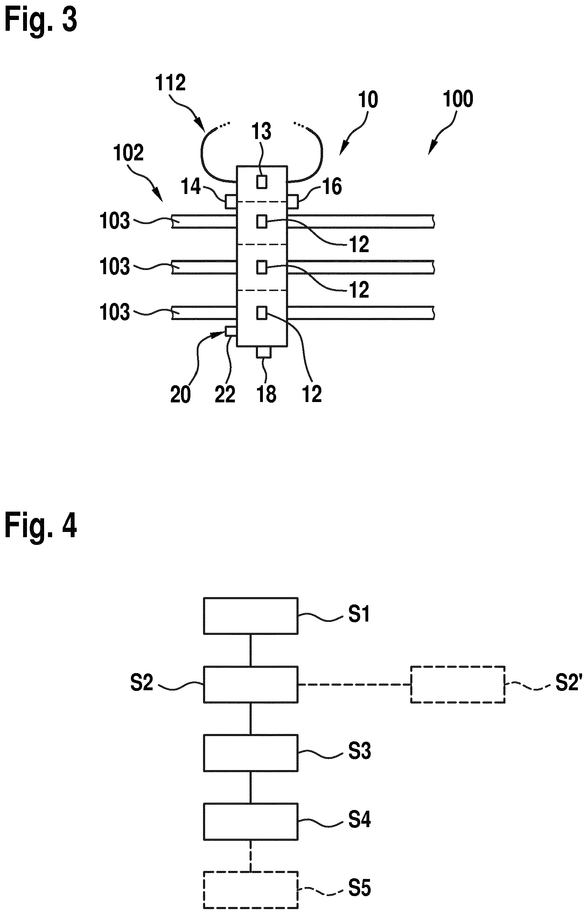

Fig. 3 zeigt eine Vorrichtung zum Ermitteln eines Betriebszustandes einer Aufzuganlage 100 gemäß einer weiteren Ausführungsform der Erfindung. Sofern nicht anders beschrieben, kann die Vorrichtung 10 der Fig. 3 dieselben Elemente und Merkmale aufweisen wie die Vorrichtungen 10 der Fig.1 und Fig. 2. Der Übersichtlichkeit halber sind einige Komponenten der Aufzuganlage 100 in Fig. 3 nicht gezeigt.

Bei dem in Fig. 3 gezeigten Ausführungsbeispiel weist die Vorrichtung 10 drei Sensorelemente 12 auf, welche jeweils an einer der drei Phasen 103 der Stromversorgungsleitung 102 angeordnet sind und/oder mit jeweils einer Phase 103 gekoppelt sind. Die Sensorelemente 12 sind jeweils dazu ausgeführt, einen Stromzeitverlauf einer einzelnen Phase 103 des der Aufzuganlage 100 über die Stromversorgungsleitung 102 zugeführten Stromes zu ermitteln.

Fig. 4 zeigt ein Flussdiagramm zur Illustration von Schritten eines erfindungsgemäßen Verfahrens zum Ermitteln eines Betriebszustandes einer Aufzuganlage gemäß einer Ausführungsform der Erfindung. Fig. 5 zeigt einen exemplarischen im Rahmen des Verfahrens der Fig. 4 ermittelten Stromzeitverlauf 500.

Im Allgemeinen kann der mit Hilfe des erfindungsgemäßen Verfahrens und/oder der Vorrichtung 10 ermittelte Betriebszustand der Aufzuganlage 100 einen Bewegungszustand einer Kabine der Aufzuganlage 100, eine Anzahl von mit der Kabine angefahrenen Stockwerken, eine Anzahl vollständiger Fahrzyklen der Kabine, einen Betriebszustand einer Aufzugtür, eine Position der Kabine und/oder einen Betriebszustand des Sicherheitskreises 112 der Aufzuganlage 100 umfassen. Der Bewegungszustand der Kabine kann beispielswiese ein Standby bzw. Ruhezustand, eine relative und/oder absolute Standby-Zeit, eine relative und/oder absolute Fahrzeit, eine Aufwärtsbewegung und/oder eine Abwärtsbewegung sein. Der Betriebszustand der Aufzugtür kann beispielsweise eine offene, eine geschlossene, eine öffnende, eine schließende und/oder eine Anzahl von Türbewegungen sein.

Zur Ermittlung eines der möglichen Betriebszustände der Aufzuganlage 100 wird in einem ersten Schritt S1 mit Hilfe der Vorrichtung 10 und insbesondere mit Hilfe des wenigstens einen Sensorelements 12, 13 der Vorrichtung 10 ein Stromzeitverlauf 500 des der Aufzuganlage 100 zugeführten Stromes ermittelt. Der Stromzeitverlauf 500 bezeichnet dabei die Stromstärke als Funktion der Zeit, so wie in Fig. 5 gezeigt. Der Stromzeitverlauf 500 stellt somit einen differentiellen Stromverbrauch der elektrischen Verbraucher 106 der Aufzuganlage 100 dar. Beispielsweise kann das Sensorelement 12, 13 mit einer gewissen Abtastrate einen Wert der Stromstärke ermitteln, detektieren, und/oder messen. Die Werte der Stromstärke werden dann in der Speichervorrichtung 14 hinterlegt, wobei sie gegebenenfalls zusätzlich von dem Controller 16 verarbeitet, beispielsweise skaliert, werden können.

In einem weiteren Schritt S2 wird ein Stromverlaufssegment 502a-f des Stromzeitverlaufs 500 mit Hilfe der Vorrichtung 10 und insbesondere mit Hilfe des Controllers 16 identifiziert und/oder ausgewählt. Das Stromverlaufssegment 502a-f kann etwa ein Zeitsegment bzw. Zeitintervall des Stromzeitverlaufs 500 bezeichnen, welches etwa über eine Anfangszeit, eine Endzeit und/oder eine Zeitdauer des Stromverlaufssegments 502a-f charakterisiert sein kann. Vorzugsweise ist das identifizierte und/oder ausgewählte Stromverlaufssegment 502a-f ein Bereich des Stromzeitverlaufs 500, welcher einem der möglichen Betriebszustände der Aufzuganlage 100 zugeordnet werden kann.

Das Stromverlaufssegment 502a-f kann dabei direkt identifiziert werden, beispielsweise durch Identifizieren eines Bereichs des Stromzeitverlaufs 500, in welchem die Stromstärke über einem gewissen Ruheniveau liegt. Optional kann der Stromzeitverlauf 500 in einem Schritt S2' mit Hilfe der Vorrichtung 10 in mehrere Stromverlaufssegmente 502a-f segmentiert werden, welche idealerweise jeweils einem Betriebszustand der Aufzuganlage 100 zugeordnet sein können.

In einem weiteren Schritt S3 wird mit Hilfe der Vorrichtung 10 und insbesondere mit Hilfe des Controllers 16 ein Stromverlaufsmuster des in Schritt S2 identifizierten und/oder ausgewählten Stromverlaufssegments 502a-f abgeleitet, ermittelt und/oder bestimmt. Das Stromverlaufsmuster weist dabei wenigstens einen für den jeweiligen Betriebszustand charakteristischen Parameter auf, und in Schritt S3 wird ein Wert des für den jeweiligen Betriebszustand charakteristischen wenigstens einen Parameters bestimmt. Mögliche Parameter des Stromverlaufsmusters können beispielsweise eine Standardabweichung eines Peaks, ein Maximalwert, ein Schwellenwert, ein Integral und/oder ein Gradient des Stromes in dem Stromverlaufssegment 502a-f umfassen. Auch eine Anzahl lokaler Maxima oder Minima in dem Stromverlaufssegment 502a-f und/oder ein (zeitlicher) Abstand von Peaks in dem Stromverlaufssegment 500 können mögliche Parameter des Stromverlaufsmusters sein. Dementsprechend kann der Schritt S3 ein Bestimmen, Ermitteln und/oder Berechnen von Werten der Parameter des Stromverlaufsmusters umfassen.

Zur eigentlichen Ermittlung eines der möglichen Betriebszustände der Aufzuganlage 100 sind in der Speichervorrichtung 14 der Vorrichtung 10 Referenzmuster hinterlegt. Analog den Stromverlaufsmustern weisen die Referenzmuster jeweils wenigstens einen für den jeweiligen Betriebszustand charakteristischen Referenzparameter bzw. einen Referenzwert des Referenzparameters auf. Mögliche Referenzparameter können beispielsweise eine Standardabweichung eines Peaks, ein Maximalwert, ein Schwellenwert, ein Integral und/oder ein Gradient des Stromes umfassen. Auch eine Anzahl lokaler Maxima oder Minima und/oder ein (zeitlicher) Abstand von Peaks können mögliche Referenzparameter in dem Referenzmuster hinterlegt sein. Für jeden möglichen Betriebszustand der Aufzuganlage kann ein Referenzmuster in der Speichervorrichtung 14 hinterlegt sein. Beispielsweise kann ein Referenzmuster für eine Aufwärtsfahrt der Kabine, eine Abwärtsfahrt der Kabine, ein Öffnen einer Tür und eine Schließen einer Tür hinterlegt sein.

Der eigentliche Betriebszustand der Aufzuganlage 100 für ein Stromverlaufssegment 502a-f wird in einem Schritt S4 basierend auf einem Vergleich des Stromverlaufsmusters eines der Stromverlaufssegmente 502a-f mit wenigstens einem in der Speichervorrichtung 14 hinterlegten Referenzmuster ermittelt. Genauer werden in Schritt S4 die Werte der in Schritt S3 abgeleiteten Parameter des Stromverlaufsmusters des in Schritt S2 identifizierten Stromverlaufssegments 502a-f mit den Referenzwerten der Referenzparametern verglichen, so dass bei Übereinstimmung der Werte mit den Referenzwerten innerhalb definierbarer Toleranzgrenzen ein Referenzmuster für das in Schritt S2 identifizierte Stromverlaufssegment 502a-f bestimmt werden kann. Nachdem jedes Referenzmuster wiederum einem gewissen Betriebszustand zugeordnet ist, kann so der Betriebszustand der Aufzuganlage 100 ermittelt werden.

Wird beispielsweise in Schritt S2 das Stromverlaufssegment 502a identifiziert und/oder ausgewählt, so kann das in Schritt S3 abgeleitete Stromverlaufsmuster beispielsweise drei Peaks, einen Abstand der Peaks, eine Standardabweichung jeden Peaks und/oder ein Integral der Stromstärke über die Zeitdauer des Stromverlaufssegments 502a aufweisen. Diese Werte können dann mit den Referenzwerten der Referenzmuster verglichen werden, wobei das Referenzmuster für eine schließende Tür der Aufzuganlage dem Stromverlaufsmuster am ähnlichsten sein kann. Entsprechend kann dann dem Stromverlaufssegment 502a der Betriebszustand einer schließenden Tür zugeordnet werden.

Analog kann beispielsweise dem Stromverlaufssegment 502b eine Abwärtsfahrt der Kabine, dem Segment 502c ein Öffnen der Tür, dem Segment 502d ein Schließen der Tür, dem Segment 502e eine Aufwärtsfahrt der Kabine und dem Segment 502f ein Öffnen der Tür zugeordnet werden.

Grundsätzlich können zusätzlich zu den Referenzmustern zur Ermittlung von Betriebszuständen aufzugspezifische Ausschlusskriterien berücksichtigt werden, wie zum Beispiel dass eine Fahrt der Kabine und ein gleichzeitiges Öffnen oder Schließen der Tür ausgeschlossen sind. Dies kann eine Genauigkeit der Ermittlung des Betriebszustandes steigern und auch eine Ermittlung des eigentlichen Betriebszustandes beschleunigen, weil beispielsweise in Schritt S4 das Stromverlaufsmuster nur mit den in Frage kommenden Referenzmustern verglichen werden muss. Auch weitere aufzugspezifische Randbedingungen, wie etwa dass in der Regel vor einer Kabinenfahrt die Aufzugtür geschlossen und nach einer Kabinenfahrt die Aufzugtür geöffnet wird, können bei der Ermittlung der Betriebszustände berücksichtigt werden.

Entsprechend den in Schritt S4 ermittelten Betriebszuständen kann in einem optionalen Schritt S5 ein Wert eines einem der Betriebszustände zugeordneten

Betriebszustandsparameters in der Speichervorrichtung 14 hinterlegt werden. Für jeden möglichen Betriebszustand der Aufzuganlage kann wenigstens ein Betriebszustandsparameter hinterlegt sein. Der Betriebszustandsparameter kann beispielsweise ein Zähler sein, dessen Wert angeben kann, wie oft ein bestimmter Betriebszustand bisher aufgetreten ist. Auch kann der Betriebszustandsparameter ein Indikator, z.B. ein Flag, sein, dessen Wert ein Vorliegen oder Nichtvorliegen eines gewissen Betriebszustandes anzeigen kann.

Ferner kann bei gewissen Betriebszuständen, wie z.B. einer Fahrt der Kabine, auch weitere Information aus dem entsprechenden Stromverlaufssegment 502a-f gezogen werden. Beispielsweise kann basierend auf dem Stromzeitverlauf 500 in einem Stromverlaufssegment 502a-f etwa eine mit der Kabine beförderte Last und/oder eine Anzahl angefahrener Stockwerke bestimmt werden. Auch derartige Information kann in Form wenigstens eines Betriebszustandsparameters in der Speichervorrichtung 14 hinterlegt sein. Zum Beispiel kann ein Betriebszustandsparameter eine Anzahl von Türbewegungen, eine Anzahl angefahrener Stockwerke oder eine Anzahl von Fahrzyklen sein.

Werte der Betriebszustandsparameter können dynamisch während des Betriebes der Aufzuganlage 100 aktualisiert, angepasst und/oder modifiziert werden. Insbesondere die Werte der Betriebszustandsparameter können über die Kommunikationsvorrichtung 18 ausgelesen und/oder übermittelt werden. Auch können über die Kommunikationsvorrichtung 18 beispielsweise die Referenzmuster in der Speichervorrichtung 14 hinterlegt und/oder aktualisiert werden.

Die Vorrichtung 10 kann überdies selbstlernend ausgestaltet sein. Beispielsweise kann die Vorrichtung 10 dazu ausgeführt sein, ein in Schritt S3 abgeleitetes Stromverlaufsmuster als Referenzmuster auszuwählen und in der Speichervorrichtung 14 als Referenzmuster zu hinterlegen. Dementsprechend kann das erfindungsgemäße Verfahren einen Schritt des Auswählens eines Stromverlaufsmusters als Referenzmuster sowie einen Schritt des Hinterlegens dieses Stromverlaufsmusters als Referenzmuster in der Speichervorrichtung 14 aufweisen.

Zusammenfassend können Ausführungsformen des hierin beschriebenen Verfahrens bzw. einer entsprechend ausgestalteten Vorrichtung dazu geeignet sein, Betriebszustände innerhalb einer Aufzuganlage in einfacher Weise zu erfassen bzw. zu überwachen. Hierzu kann ein Stromzeitverlauf vorzugsweise in einer Hauptversorgungsleitung der Aufzuganlage überwacht werden und anhand von darin auftretenden Mustern auf das Vorliegen bestimmter Betriebszustände rückgeschlossen werden. Zu diesem Zweck kann ein vorzugsweise kontaktlos messender Sensor, d.h. ein von der Versorgungsleitung galvanisch getrennter Sensor, an der Versorgungsleitung angeordnet werden. Ein solcher Sensor kann auch von Personal montiert werden, dass nicht über tiefes elektrotechnisches Wissen verfügt. Insbesondere kann der Sensor auch an Aufzuganlagen angeordnet werden, deren genaue elektrische Funktionsweise nicht bekannt ist, d.h. von denen beispielsweise kein Schaltplan bekannt ist. Das beschriebene Verfahren bzw. eine dieses Verfahren ausführende Vorrichtung kann somit an Aufzuganlagen nachgerüstet werden und dann, evtl. nach einer Einlernphase, Betriebszustände innerhalb der Aufzuganlage anhand einer Mustererkennung im Stromzeitverlauf einer Stromversorgung der Aufzuganlage erkennen und zuordnen.

Ergänzend ist darauf hinzuweisen, dass "umfassend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

## Patentansprüche

1. Verfahren zum Ermitteln eines Betriebszustandes einer Aufzuganlage (100), das Verfahren aufweisend die Schritte:
Ermitteln eines Stromzeitverlaufs (500) eines der Aufzuganlage (100) über eine Stromversorgungsleitung (102) der Aufzuganlage (100) zugeführten Stromes;
Identifizieren wenigstens eines Stromverlaufssegments (502a-f) des erfassten Stromzeitverlaufs (500);
Ableiten eines Stromverlaufsmusters des identifizierten Stromverlaufssegments (502a-f); und
Ermitteln des Betriebszustandes der Aufzuganlage (100) basierend auf einem Vergleich des Stromverlaufsmusters mit wenigstens einem Referenzmuster.

2. Verfahren nach Anspruch 1,
wobei der Stromzeitverlauf (500) in der Stromversorgungsleitung (102) mit wenigstens einem galvanisch von der Stromversorgungsleitung (102) getrennten Sensorelement (12, 13) ermittelt wird; und/oder
wobei die Stromversorgungsleitung (102) eine Hauptversorgungsleitung zu einem Schaltschrank (104) der Aufzuganlage (100) umfasst.

3. Verfahren nach einem der Ansprüche 1 oder 2,
wobei der Betriebszustand unter Berücksichtigung von aufzugspezifischen Ausschlusskriterien und/oder aufzugspezifischen Randbedingungen ermittelt wird.

4. Verfahren nach einem der voranstehenden Ansprüche,
wobei das Stromverlaufsmuster wenigstens einen für einen jeweiligen Betriebszustand charakteristischen Parameter aufweist; und/oder
wobei der Schritt des Ableitens des Stromverlaufsmusters ein Bestimmen eines Wertes des für den jeweiligen Betriebszustand charakteristischen wenigstens einen Parameters umfasst.

5. Verfahren nach Anspruch 4,
wobei das Referenzmuster wenigstens einen für den jeweiligen Betriebszustand charakteristischen Referenzparameter aufweist; und/oder
wobei der jeweilige Betriebszustand basierend auf einem Vergleich des Wertes des wenigstens einen für den jeweiligen Betriebszustand charakteristischen Parameters mit einem Referenzwert des wenigstens einen Referenzparameters des Referenzmusters ermittelt wird.

6. Verfahren nach einem der voranstehenden Ansprüche,
wobei der Schritt des Ableitens des Stromverlaufsmusters des Stromverlaufssegments (502a-f) ein Ermitteln einer Standardabweichung, eines Maximalwerts, eines Schwellenwertes, eines Mittelwertes, eines Wertes im Frequenzbereich, eines Integrals und/oder eines Gradienten des Stromes in dem Stromverlaufssegment (502a-f) umfasst.

7. Verfahren nach einem der voranstehenden Ansprüche,
wobei der Schritt des Identifizierens des wenigstens einen Stromverlaufssegments (502a-f) ein Segmentieren des erfassten Stromzeitverlaufs (500) in Stromverlaufssegmente (502a-f) umfasst.

8. Verfahren nach einem der voranstehenden Ansprüche, weiter aufweisend:
Auswählen eines Stromverlaufssegments als Basis zur Ermittlung eines Stromverlaufsmusters als Referenzmuster; und/oder
Hinterlegen des Stromverlaufsmusters als Referenzmuster in einer Speichervorrichtung (14).

9. Verfahren nach einem der voranstehenden Ansprüche,
wobei der ermittelte Betriebszustand einen Bewegungszustand einer Kabine der Aufzuganlage (100), eine Anzahl von mit der Kabine angefahrenen Stockwerken, eine Anzahl vollständiger Fahrzyklen der Kabine, einen Betriebszustand einer Aufzugtür, eine Position der Kabine und/oder einen Betriebszustand eines Sicherheitskreises der Aufzuganlage (100) umfasst.

10. Computerprogrammprodukt, welches maschinenlesbare Anweisungen aufweist, welche eine programmierbare Vorrichtung zum Ausführen des Verfahrens nach einem der voranstehenden Ansprüche anweisen.

11. Computerlesbares Medium mit einem darauf gespeicherten Computerprogrammprodukt gemäß Anspruch 10.

12. Vorrichtung (10) zum Ermitteln eines Betriebszustandes einer Aufzuganlage (100), aufweisend:
wenigstens ein Sensorelement (12, 13);
eine Speichervorrichtung (14); und
einen Controller (16),
**dadurch gekennzeichnet, dass** das Sensorelement (12, 13) dazu ausgeführt ist, den Stromzeitverlauf (500) des der Aufzuganlage (100) über die Stromversorgungsleitung (102) der Aufzuganlage (100) zugeführten Stromes zu ermitteln; und
wobei der Controller (16) dazu ausgeführt ist, das wenigstens eine Stromverlaufssegment (502a-f) des ermittelten Stromzeitverlaufs (500) zu identifizieren, das Stromverlaufsmuster des identifizierten Stromverlaufssegments (502a-f) abzuleiten, das Stromverlaufsmuster mit dem wenigstens einen Referenzmuster zu vergleichen, den Betriebszustand der Aufzuganlage (100) basierend auf dem Vergleich zu ermitteln, und einen Wert wenigstens eines dem Betriebszustand zugeordneten Betriebszustandsparameters in der Speichervorrichtung (14) zu hinterlegen.

13. Vorrichtung (10) gemäß Anspruch 12,
wobei das Sensorelement (12, 13) einen induktiven Stromsensor und/oder einen Hall-Sensor aufweist.

14. Vorrichtung (10) gemäß einem der Ansprüche 12 oder 13,
wobei die Vorrichtung (10) eine Mehrzahl von Sensorelementen (12, 13) aufweist, welche jeweils dazu ausgeführt sind, einen Stromzeitverlauf (500) einer einzelnen Phase (103) des der Aufzuganlage (100) über die Stromversorgungsleitung (102) zugeführten Stromes zu ermitteln.

15. Vorrichtung (10) nach einem der Ansprüche 12 bis 14,
wobei die Vorrichtung (10) ein weiteres Sensorelement (13) aufweist,
wobei das weitere Sensorelement (13) dazu ausgeführt ist, einen Stromzeitverlauf (500) eines Stromes in einem Sicherheitskreis (102) der Aufzuganlage (100) zu ermitteln.

16. Vorrichtung (10) nach einem der Ansprüche 12 bis 15, weiter aufweisend:
eine Energiequelle (20) zum Versorgen der Vorrichtung (10) mit elektrischer Energie,
wobei die Energiequelle (20) einen Energiespeicher (22) aufweist, der dazu ausgeführt ist, zumindest teilweise über ein von in der Stromversorgungsleitung (102) fließendem Strom erzeugtes Magnetfeld geladen zu werden.

17. Vorrichtung (10) nach einem der Ansprüche 12 bis 16, weiter aufweisend:
eine Kommunikationsvorrichtung (18) zum Übermitteln von in der Speichervorrichtung (14) hinterlegten Werten von Betriebszuständen der Aufzuganlage zugeordneten Betriebszustandsparametern.

## Claims

1. Method for determining an operating state of an elevator system (100), the method having the steps:
determining a current/time profile (500) of a current supplied to the elevator system (100) via a power supply line (102) of the elevator system (100);
identifying at least one current profile segment (502a-f) of the detected current/time profile (500);
deriving a current profile pattern of the identified current profile segment (502a-f); and
determining the operating state of the elevator system (100) based on comparing the current profile pattern to at least one reference pattern.

2. The method according to claim 1,
wherein the current/time profile (500) in the power supply line (102) is determined with at least one sensor element (12, 13) galvanically separated from the power supply line (102), and/or
wherein the power supply line (102) comprises a main power supply line to a control cabinet (104) for the elevator system (100).

3. The method according to either of claims 1 or 2,
wherein the operating state is determined taking into account elevator-specific exclusion criteria and/or elevator-specific marginal conditions.

4. The method according to any of the preceding claims,
wherein the current profile pattern has at least one characteristic parameter for each operating state, and/or
wherein the step of deriving the current profile pattern comprises determining a value of the at least one parameter that is characteristic for the specific operating state.

5. The method according to claim 4,
wherein the reference pattern has at least one reference parameter that is characteristic for each operating state, and/or
wherein the specific operating state is determined based on a comparison of the value of the at least one parameter that is characteristic of the specific operating state to a reference value of the at least one reference parameter of the reference pattern.

6. The method according to any of the preceding claims,
wherein the step of deriving the current profile pattern of the current profile segment (502a-f) comprises determining a standard deviation, a maximum value, a threshold value, a mean value, a value in the frequency range, an integral and/or a gradient of the current in the current profile segment (502a-f).

7. The method according to any of the preceding claims,
wherein the step of identifying the at least one current profile segment (502a-f) comprises segmenting the detected current/time profile (500) into current profile segments (502a-f).

8. The method according to any of the preceding claims, further comprising:
selecting a current profile segment as the basis for determining a current profile pattern as reference pattern, and/or
storing the current profile pattern as reference pattern in a storage device (14).

9. The method according to any of the preceding claims,
wherein the determined operating state comprises a movement state of a car of the elevator system (100), a number of floors traveled with the car, a number of complete travel cycles for the car, an operating state of an elevator door, a position of the car, and/or an operating state of a safety circuit of the elevator system (100).

10. A computer program product that has machine-readable instructions that instruct a programmable device to execute the method according to any of the preceding claims.

11. A computer-readable medium that has a computer program product according to claim 10 stored thereon.

12. A device (10) for determining an operating state of an elevator system (100) having:
at least one sensor element (12, 13),
a storage device (14), and,
a controller (16),
**characterized in that** the sensor element (12, 13) is embodied to determine the current/time profile (500) of the current supplied to the elevator system (100) via the power supply line (102) of the elevator system (100), and
the controller (16) being embodied to identify the at least one current profile segment (502a-f) of the determined current/time profile (500), to derive the current profile pattern of the identified current profile segment (502a-f), to compare the current profile pattern to the at least one reference pattern, to determine the operating state of the elevator system (100) based on the comparison, and to store in the storage device (14) a value of at least one operating state parameter associated with the operating state.

13. The device (10) according to claim 12,
wherein the sensor element (12, 13) has an inductive current sensor and/or a Hall sensor.

14. The device (10) according either claim 12 or 13,
wherein the device (10) has a plurality of sensor elements (12, 13) that are each embodied to determine a current/time profile (500) of an individual phase (103) for the current supplied to the elevator system (100) via the power supply line (102).

15. The device (10) according to any of claims 12 through 14,
wherein the device (10) has an additional sensor element (13),
wherein the additional sensor element (13) is embodied to detect a current/time profile (500) of a current in a safety circuit (102) of the elevator system (100).

16. The device (10) according to any of claims 12 through 15, further having:
an energy source (20) for supplying the device (10) with electrical energy,
wherein the energy source (20) has an energy storage unit (22) that is embodied to be charged, at least in part, via a magnetic field produced by current flowing in the power supply line (102).

17. The device (10) according to any of claims 12 through 16, further having:
a communication device (18) for transmitting values of operating states, stored in the storage device (14), of operating state parameters associated with the elevator system.

## Revendications

1. Procédé de détermination d'un état de fonctionnement d'une installation d'ascenseur (100), le procédé comprenant les étapes :
de détermination d'un profil temporel de courant (500) d'un courant fourni à l'installation d'ascenseur (100) par l'intermédiaire d'une ligne d'alimentation électrique (102) de l'installation d'ascenseur (100) ;
d'identification d'au moins un segment de profil de courant (502a-f) du profil temporel de courant (500) détecté ;
de dérivation d'un modèle de profil de courant du segment de profil de courant (502a-f) identifié ; et
de détermination de l'état de fonctionnement de l'installation d'ascenseur (100) sur la base d'une comparaison du modèle de profil de courant avec au moins un modèle de référence.

2. Procédé selon la revendication 1, dans lequel le profil temporel de courant (500) dans la ligne d'alimentation électrique (102) est déterminé par au moins un élément capteur (12, 13) qui est galvaniquement isolé de la ligne d'alimentation électrique (102) ; et/ou
dans lequel la ligne d'alimentation électrique (102) comprend une ligne d'alimentation électrique principale menant à une armoire de commande (104) de l'installation d'ascenseur (100).

3. Procédé selon l'une des revendications 1 ou 2, dans lequel l'état de fonctionnement est déterminé en tenant compte de critères d'exclusion spécifiques à l'ascenseur et/ou de contraintes spécifiques à l'ascenseur.

4. Procédé selon l'une des revendications précédentes, dans lequel le modèle de profil de courant présente au moins un paramètre caractéristique d'un état de fonctionnement respectif ; et/ou
l'étape de dérivation du modèle de profil de courant comprend la détermination d'une valeur de l'au moins un paramètre caractéristique de l'état de fonctionnement respectif.

5. Procédé selon la revendication 4, dans lequel le modèle de référence présente au moins un paramètre de référence caractéristique de l'état de fonctionnement respectif; et/ou
dans lequel l'état de fonctionnement respectif est déterminé sur la base d'une comparaison de la valeur de l'au moins un paramètre caractéristique de l'état de fonctionnement respectif avec une valeur de référence de l'au moins un paramètre de référence du modèle de référence.

6. Procédé selon l'une des revendications précédentes, dans lequel l'étape de dérivation du modèle de profil de courant du segment de profil de courant (502a-f) comprend une détermination d'un écart type, d'une valeur maximale, d'une valeur seuil, d'une valeur moyenne, d'une valeur dans la plage de fréquences, d'une intégrale et/ou d'un gradient du courant dans le segment de profil de courant (502a-f).

7. Procédé selon l'une des revendications précédentes, dans lequel l'étape d'identification de l'au moins un segment de profil de courant (502a-f) comprend la segmentation du profil temporel de courant (500) détecté en segments de profil de courant (502a-f).

8. Procédure selon l'une des revendications précédentes, comprenant en outre :
la sélection d'un segment de profil de courant comme base pour déterminer un modèle de profil de courant comme modèle de référence ; et/ou
le stockage du modèle de profil de courant comme modèle de référence dans un dispositif de stockage (14).

9. Procédé selon l'une des revendications précédentes, dans lequel l'état de fonctionnement déterminé comprend un état de déplacement d'une cabine de l'installation d'ascenseur (100), un nombre d'étages parcourus par la cabine, un nombre de cycles de déplacement complets de la cabine, un état de fonctionnement d'une porte d'ascenseur, une position de la cabine et/ou un état de fonctionnement d'un circuit de sécurité de l'installation d'ascenseur (100).

10. Produit de programme informatique comprenant des instructions lisibles par machine permettant à un dispositif programmable d'exécuter le procédé selon l'une des revendications précédentes.

11. Support lisible par ordinateur sur lequel est stocké un produit de programme informatique conformément à la revendication 10.

12. Dispositif (10) destiné à déterminer un état de fonctionnement d'une installation d'ascenseur (100), comprenant :
au moins un élément capteur (12, 13) ;
un dispositif de stockage (14) ; et
un dispositif de commande (16),
**caractérisé en ce que** l'élément capteur (12, 13) est conçu pour déterminer le profil temporel de courant (500) du courant fourni à l'installation d'ascenseur (100) par l'intermédiaire de la ligne d'alimentation électrique (102) de l'installation d'ascenseur (100) ; et
le dispositif de commande (16) étant conçu pour identifier au moins un segment de profil de courant (502a-f) du profil temporel de courant détecté (500), dériver le modèle de profil de courant du segment de profil de courant (502a-f) identifié, comparer le modèle de profil de courant avec l'au moins un modèle de référence, détecter l'état de fonctionnement de l'installation d'ascenseur (100) sur la base de la comparaison, et stocker une valeur d'au moins un paramètre de fonctionnement associé à l'état de fonctionnement dans le dispositif de stockage (14).

13. Dispositif (10) selon la revendication 12, dans lequel l'élément capteur (12, 13) est doté d'un capteur de courant inductif et/ou d'un capteur à effet Hall.

14. Dispositif (10) selon l'une des revendications 12 ou 13, le dispositif (10) comprenant une pluralité d'éléments capteurs (12, 13) conçus chacun pour déterminer un profil temporel de courant (500) d'une phase unique (103) du courant fourni à l'installation d'ascenseur (100) par l'intermédiaire de la ligne d'alimentation électrique (102).

15. Dispositif (10) selon l'une des revendications 12 à 14, le dispositif (10) comprenant un élément capteur (13) supplémentaire, l'élément capteur (13) supplémentaire étant conçu pour déterminer un profil temporel de courant (500) d'un courant dans un circuit de sécurité (102) de l'installation d'ascenseur (100).

16. Dispositif (10) selon l'une des revendications 12 à 15 comprenant en outre :
une source d'énergie (20) destinée à fournir de l'énergie électrique au dispositif (10), la source d'énergie (20) comprenant un accumulateur d'énergie (22) conçu pour être chargé au moins partiellement par un champ magnétique généré par un courant circulant dans la ligne d'alimentation électrique (102).

17. Dispositif (10) selon l'une des revendications 12 à 16 comprenant en outre :
un dispositif de communication (18) permettant de transmettre les valeurs des états de fonctionnement des paramètres d'état de fonctionnement associés à l'installation d'ascenseur, lesquelles valeurs sont stockées dans le dispositif de stockage (14).
